# EUROPEAN PATENT APPLICATION

(11) **EP 1 923 932 A2**
(43) Date of publication of application: **21.05.2008**
(21) Application number: 07254516.3
(22) Date of filing: 20.11.2007
(51) Int. Cl.: H01L 51/52

(54) **Luminescent sheet having see-through property, luminescent decorative material, and method of producing the same**

(30) Priority: 20.11.2006 JP 2006312815
(71) Applicant: Lintec Corporation, Tokyo 173-0001 (JP)
(72) Inventor: Okuji, Shigeto c/o Lintec Corporation, Tokyo 173-0001 (JP); Sekiya, Masahiko Lintec Corporation, Tokyo 173-0001 (JP); Hoshi, Shinichi Lintec Corporation, Tokyo 173-0001 (JP)
(74) Representative: Nicholls, Michael John

(57) **Abstract**

This invention relates to a luminescent sheet having see-through property, through which see-through holes are formed and which comprises a means of causing luminescence; a method of producing the luminescent sheet, comprising carrying out perforation processing on a sheet body comprising a means of causing luminescence so as to impart see-through property to such sheet body; and a method of producing the luminescent sheet, comprising carrying out perforation processing on a sheet body so as to impart see-through property to such sheet body and then applying a means of causing luminescence to the sheet body.

According to this invention, a luminescent decorative material having see-through property, which is visible even at night and of which different decorative properties are visible in the daytime or under lighting due to the presence or absence of luminescence, is provided.

## Description

The present invention relates to luminescent sheets and luminescent decorative materials used as advertising media, decorative media, or security sheets, which are applied to windows of commercial buildings, vehicles, and the like, and also relates to a method of producing the same.

In order to produce a special-purpose decorative material (sheet) having see-through property, in which different images are separately formed each other on both sides of the sheet, the following methods and the like have been suggested and practically used: a method of obtaining a special-purpose decorative material, wherein sheets, upon each of which an image consisting of different pixels is drawn in dots, are laminated to each other in an accurate manner and then one of the sheets is removed from the other, such that pixels of the removed sheet are transferred onto pixels of the other sheet (JP Patent Publication (Kokai) No. 5-92694 A (1993)); and a method wherein inks having different adhesion properties are used for image drawing and then unnecessary ink portions are selectively removed using an adhesive sheet (JP Patent Publication (Kokai) No. 5-92695 A (1993)). At present, in view of design properties, special-purpose decorative materials have been widely used in stores and on commercial vehicles for both commercial and private uses.

However, special-purpose decorative materials produced by the above methods have the drawback of being only visible in the daytime or under lighting, but being invisible at night.

It is an objective of the present invention to provide a luminescent decorative material, which is visible even in no-light environments at night and of which different decorative properties are visible in the daytime or under lighting due to the presence or absence of luminescence caused by intentional switching of a power source between on-off modes.

The present invention is summarized as follows.
(1) A luminescent sheet having see-through property, through which see-through holes are formed, and which comprises a means of causing luminescence.
(2) The luminescent sheet according to item (1), wherein the means of causing luminescence is the luminescent sheet itself.
(3) The luminescent sheet according to item (1), wherein the means of causing luminescence is a luminescent tube that is provided around the edges of the sheet.
(4) The luminescent sheet according to any one of items (1) to (3), which has been subjected to perforation processing in a matrix pattern.
(5) The luminescent sheet according to any one of items (1) to (4), which has a see-through control region.
(6) A luminescent decorative material, which is obtained by printing on at least one face of the luminescent sheet according to item (1).
(7) A method of producing the luminescent sheet according to any one of items (1), (2), and (4) to (6), comprising carrying out perforation processing on a sheet body comprising a means of causing luminescence so as to impart see-through property to such sheet body.
(8) A method of producing the luminescent sheet according to any one of items (1), (3), and (4) to (6), comprising carrying out perforation processing on a sheet body so as to impart see-through property to such sheet body and then applying a means of causing luminescence to the sheet body.

According to the present invention, it is possible to provide a luminescent decorative material, of which a wide variety of decorative properties are visible under various lighting environments such as day and night environments and well-lit and dark rooms.
Fig. 1 shows a cross-sectional view of a luminescent decorative material having see-through property produced in Example 1.
Fig. 2 shows steps of the production process used in Example 1.
Fig. 3 shows a cross-sectional view of a luminescent decorative material having see-through property produced in Example 2.
Fig. 4 shows steps of the production process used in Example 2.
Fig. 5 shows steps of the production process used in Example 3.
Fig. 6 shows a state in which perforation processing has been carried out in a matrix pattern.
Fig. 7 shows a state in which perforation processing has been carried out in a matrix pattern.

Each numeral in the figures means the following.
- 1: polyethylene terephthalate sheet (transparent substrate)
- 2: ITO (1^{st} electrode layer)
- 3: polyethylene terephthalate sheet (transparent substrate)
- 4: luminescent layer (ZnS:Cu)
- 5: ITO (2^{nd} electrode layer)
- 6: luminescent sheet
- 7: designed luminescent sheet
- 8: luminescent decorative material having see-through property
- 9: dielectric layer (barium titanate)
- 10: sheet
- 11: conductive paste
- 12: adhesive sheet
- 14: transparent color ink
- 15: designed luminescent sheet
- 16: luminescent decorative material having see-through property
- 31: printed polyethylene terephthalate sheet
- 32: sheet-type decorative material having see-through property
- 33: EL tube
- 34: luminescent decorative material having see-through property

The luminescent sheet of the present invention is a sheet which comprises a means of causing luminescence from the sheet and which has been subjected to perforation processing.

With the above configuration, when the area behind the sheet body is brighter than the area in front thereof, an observer in front thereof can see the area behind the sheet body through holes made by perforation processing. In such case, even when the surface of the sheet body has an image printed thereon, such image is only visible with difficulty (but depending on brightness) and thus the area behind the sheet body is visible. Meanwhile, when the area behind the sheet body is darker than the area in front thereof, the area behind the sheet body is only visible with difficulty. In such case, if the surface of the sheet body has a text or image printed thereon, such printed text or image is clearly visible.

In addition, when luminescence is caused by the means of causing luminescence from the sheet, it becomes difficult to see through the sheet body even in a case in which the area behind the sheet body is well-lit. As a result, the sheet itself is well-lit. Further, if the surface of the sheet body has a text or image printed thereon, effects can be obtained whereby such printed text or image looks shiny due to backlight.

A means of causing luminescence from a sheet is used for luminescence of EL (electroluminescence) or the like. As a method of causing luminescence of EL (electroluminescence), a method using an EL sheet, a method wherein an EL tube is provided around the edges of a sheet, and the like can be used.

When an EL sheet is used as a means of causing luminescence from the sheet, the sheet body obtained by, for example, providing at least a 1^{st} electrode layer, a luminescent layer, and a 2^{nd} electrode layer on a transparent substrate can be used.

The aforementioned transparent substrate is not particularly limited as long as it is transparent. However, it is preferable that such transparent substrate be flexible. Examples of material used for such transparent substrate include: polyester such as polyethylene terephthalate, polybutylene terephthalate, or polyethylene naphthalate; polycarbonate; polyamide such as wholly aromatic polyamide, nylon 6, nylon 66, or nylon copolymer; polyacrylate such as polymethyl methacrylate; and glass. A sheet having a thickness of approximately 10 to 150 µm is used as such transparent substrate.

Examples of material used for a 1^{st} electrode layer include, but are not particularly limited to: a thin film made of metal oxide such as indium tin oxide (ITO), indium zinc oxide, indium oxide, or tin oxide; and a ultrathin film made of a noble metal. When a thin film made of metal oxide is used as a 1^{st} electrode layer, the thickness thereof is generally 50 to 50000 nm. A 1^{st} electrode layer can be formed by physical deposition methods such as a vacuum deposition method, an ion plating method, and a sputtering method, by chemical vapor deposition methods such as a thermal CVD (chemical vapor deposition) method, a plasma CVD method, and a photo-CVD method, or by printing or coating with the use of a conductive paste dispersed in a binder or the like.

According to the present invention, a luminescent layer is provided between a 1^{st} electrode layer and a 2^{nd} electrode layer. A luminescent layer may be formed in a planar layer in a manner such that it covers one surface of each electrode layer. Alternatively, a luminescent layer may be partially provided.

Material used for a luminescent layer is not particularly limited as long as material that can cause electroluminescence is used. Examples of such material that may be used include: inorganic EL material such as activated zinc sulfide ZnS:X (wherein X is an activator element such as Mn, Tb, Cu, Sm, or Ag), Y₂O₂S:Eu, Y₂O₃:Eu, Zn₂SiO₄:Mn, CaWO₄:Pb, BaMgAl₁₀O₁₇:Eu, CaS:Eu, SrS:Ce, SrGa₂S₄:Ce, CaGa₂S₄:Ce, CaS:Pb, BaAl₂S₄:Eu, or YVO₄:Eu; low-molecular-weight organic EL material such as an aluminum-quinolinol complex or an aromatic diamine derivative (e.g., a triphenyldiamine derivative); and polymer organic EL material such as polyphenylene vinylene. The thickness of a luminescent layer is generally 0.1 to 50 µm. For instance, when inorganic EL material is used, a luminescent layer can be formed by coating with the use of a solution containing such inorganic EL material, followed by drying. When organic EL material is used, a vacuum deposition method and an inkjet method can be used.

When an EL sheet is used, it is preferable to provide a dielectric layer for the improvement of luminescence efficiency. A dielectric layer is provided between a 1^{st} electrode layer and a 2^{nd} electrode layer and preferably between a luminescent layer and a 2^{nd} electrode layer. Preferred examples of material used for a dielectric layer include high-permittivity materials such as barium titanate, silicon oxide, silicon nitride, antimony-doped tin oxide, and yttrium oxide. The thickness of a dielectric layer is generally 0.1 to 50 µm. A dielectric layer can be formed by, for example, sputtering or by coating with the use of a solution containing the above material, followed by drying.

Material used for a 2^{nd} electrode layer is not particularly limited as long as it is conductive material. However, it is preferable that such material be formed into an opaque layer. Examples of such material include conductive paste, a metal film formed by physical deposition, or the aforementioned material used for a 1^{st} electrode layer. The thickness of a 2^{nd} electrode layer is generally 50 to 50000 nm. Examples of a method of forming a 2^{nd} electrode layer include the aforementioned methods of forming a 1^{st} electrode layer.

After a 2^{nd} electrode layer is formed, an adhesive sheet or the like that serves as a protective layer used for a 2^{nd} electrode layer is applied to a 2^{nd} electrode layer such that a luminescent sheet can be obtained.

A design can be imparted to an emitting face by printing a pattern, text, or the like on a transparent substrate with the use of, for example, a transparent color ink and a color filter or by applying an adhesive sheet subjected to printing with a transparent color ink to a transparent substrate.

Further, according to the present invention, it is preferable to provide a see-through control region having color such as black, brown or the like that causes relatively little reflection or scattering of exterior light. When such see-through control region is provided, specific effects can be obtained whereby it is difficult to see the area behind a luminescent sheet against an emitting face thereof while it is relatively easy to see the area in front of the luminescent sheet from the opposite side.

A see-through control region is provided, for example, as a see-through control layer (directly or via a dielectric layer) between a luminescent layer and a 1^{st} electrode layer or a 2^{nd} electrode layer by a method involving, for example, inkjet printing, screen printing, or gravure printing with the use of a colored conductive paste. When a colored conductive paste is used, a see-through control region is preferably provided at a location at which it is sandwiched between a 1^{st} electrode layer and a 2^{nd} electrode layer. Such colored conductive paste is not particularly limited as long as it has a color that does not cause light reflection or scattering. Examples of a conductive paste that can be used include polymer resin in which silver filler or carbon black has been dispersed and a conductive polymer obtained by doping polymer material such as polyacetylene with halogen material.

In addition, when such colored conductive paste is not used, printing is carried out on the surface of a transparent substrate by inkjet printing, screen printing, gravure printing, or the like with the use of a conventional ink that has a color that does not cause light reflection or scattering. Thus, effects similar to those obtained with the use of a colored conductive paste can be obtained.

As described above, it is possible to obtain the sheet body comprising a means of causing luminescence from the sheet.

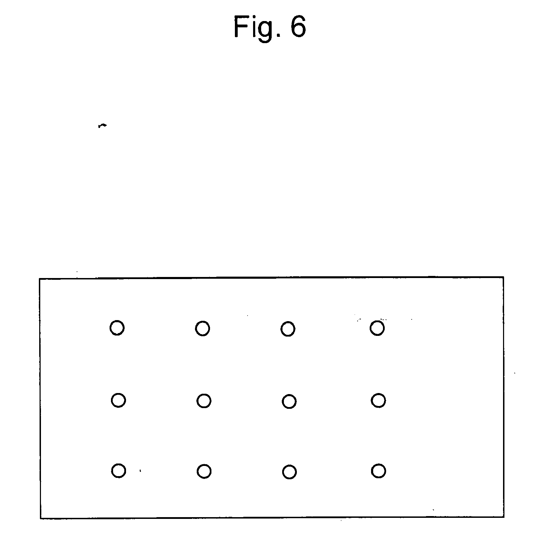

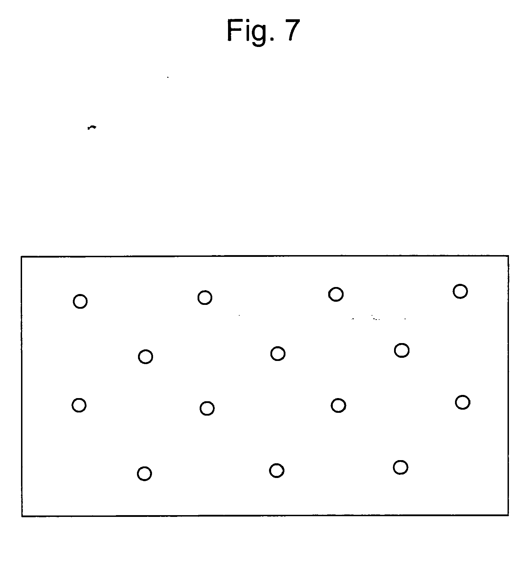

The luminescent sheet of the present invention can be obtained by allowing the above sheet body to be subjected to perforation processing. Perforation processing is not particularly limited as long as see-through property can be obtained. However, as shown in figs. 6 and 7, it is preferable that the processing be carried out in a manner such that holes with a uniform size are arranged in parallel at equal intervals in a matrix pattern.

The hole shape is not particularly limited as long as see-through property can be obtained. Examples thereof include round shapes, oval shapes, triangular shapes, rectangular shapes, polygonal shapes, and star shapes. The hole size is generally 0.1 to 50 mm and preferably 0.5 to 10 mm. The length of the interval between the centers of holes is generally 0.1 to 50 mm and preferably 0.5 to 10 mm.

A method used for perforation processing in the present invention involves punching processing such as flat die cutting (punching using a flat blade) or rotary die cutting (punching using a rotary blade), laser processing, and the like.

When a luminescent tube that serves as a means of causing luminescence from a sheet is provided around the edges of the sheet, the sheet body is subjected to perforation processing in a manner such that see-through property is imparted thereto. Then, a luminescent tube can be provided around the edges of the sheet body. An EL tube can be used as a luminescent tube. In addition, an LED, a light guide plate, and the like can be used to replace an EL tube.

When a luminescent tube is used, the above sheet body is not necessarily a luminescent sheet. Such sheet body can be obtained as follows. For instance, a pattern or text is printed on one side of a transparent substrate with the use of a transparent color ink, color filter, or the like, or an adhesive sheet subjected to printing with a transparent color ink is applied to one side of a transparent substrate. Then, printing is carried out on the other side thereof with the use of a transparent color ink, nontransparent color ink, or the like, or color filter or the like is applied thereto.

The luminescent sheet of the present invention can be obtained by carrying out perforation processing on the sheet body as described above and providing a luminescent tube around the edges of the sheet body. The luminescent tube used is not particularly limited, and thus a variety of commercially available luminescent tubes can be used.

In cases in which the luminescent sheet of the present invention that serves as a luminescent decorative material is used as an advertising medium, a decorative medium, or a security sheet that is applied to signboards or windows of commercial buildings, vehicles, and the like, such luminescent decorative material can be protected by applying a protective sheet to both sides thereof. Such protective sheet to be used is not particularly limited as long as it is transparent. Preferably, an anti-scratch (hard-coating) treatment is carried out on such protective sheet. When such luminescent decorative material is attached to a wall or a window glass, a variety of commercially available adhesives can be used.

### Examples

The present invention is hereafter described in greater detail with reference to the following examples, although the technical scope of the present invention is not limited thereto.

### (Example 1)

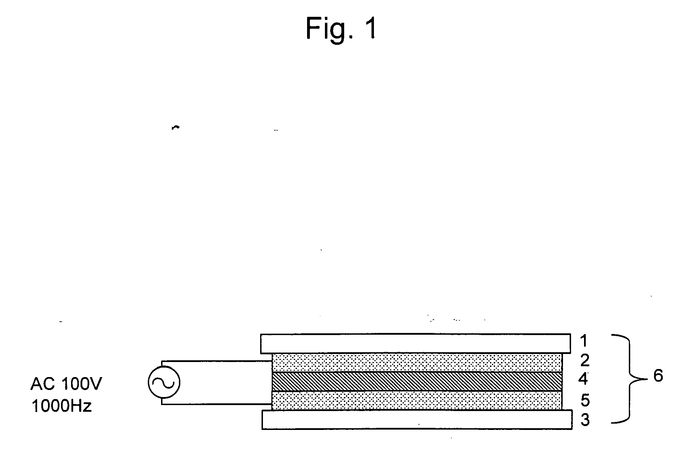

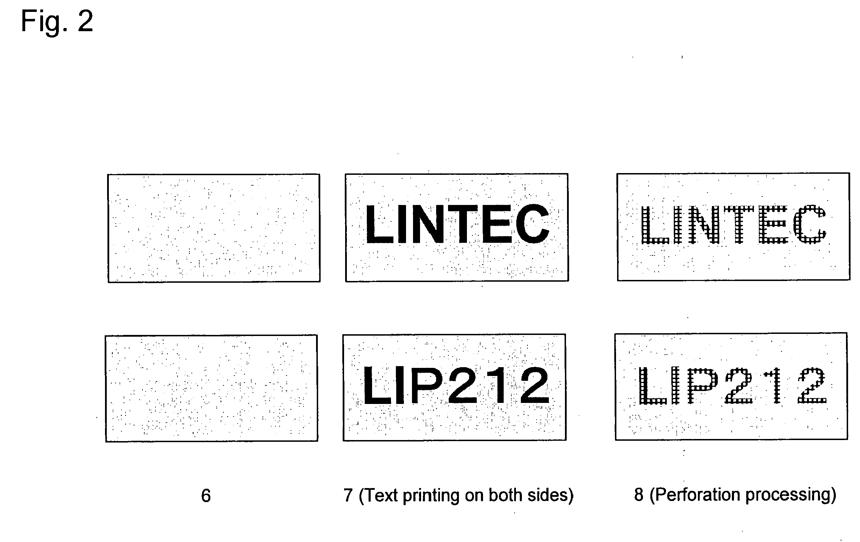

The present invention is explained below with reference to figs. 1 and 2.

A 1^{st} electrode layer 2 (100 nm in thickness) was formed by ITO sputtering on a polyethylene terephthalate sheet 100 µm in thickness (DIAFOIL T-100, Mitsubishi Polyester Film Corporation) serving as a transparent substrate 1. A 2^{nd} electrode layer 5 (100 nm in thickness) was formed by ITO sputtering on another polyethylene terephthalate sheet 100 µm in thickness (DIAFOIL T-100, Mitsubishi Polyester Film Corporation) serving as a 2^{nd} transparent substrate 3. Subsequently, a ZnS:Cu solution (FEL-190, Fujikura Kasei Co., Ltd.) was coated to the ITO face of the 1^{st} electrode layer 2 such that a luminescent layer 4 was formed to have a thickness of 40 µm. The ITO face of the 2^{nd} electrode layer 5 was laminated to the luminescent layer 4 in a manner such that they were bonded together. Drying was carried out using a dryer at 100°C for 30 minutes. Accordingly, a luminescent sheet 6 was obtained. Subsequently, text was printed on both sides of the luminescent sheet 6 using an ink (SS-66, TOYO INK MFG. CO., LTD.) such that a designed luminescent sheet 7 was produced. Such designed luminescent sheet was subjected to perforation processing using a flat die cutter (RFP-S20, UHT CORPORATION) in a manner such that 1-mm holes were formed thereon at 2-mm intervals between the centers of holes in a matrix pattern. Accordingly, a luminescent decorative material 8 having see-through property was obtained. An AC voltage of 100 V with a frequency of 1000 Hz was applied to the thus obtained luminescent decorative material 8 in the direction of the material's thickness. As a result, the luminescent decorative material was confirmed to be excellent in visibility even at night, and furthermore, to have see-through property.

### (Example 2)

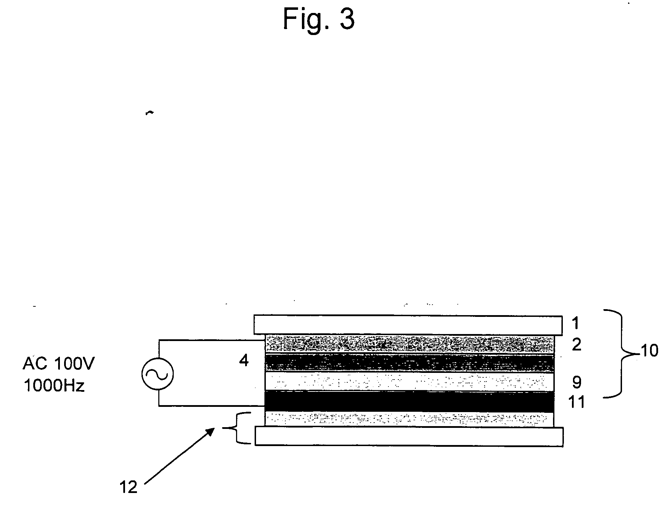

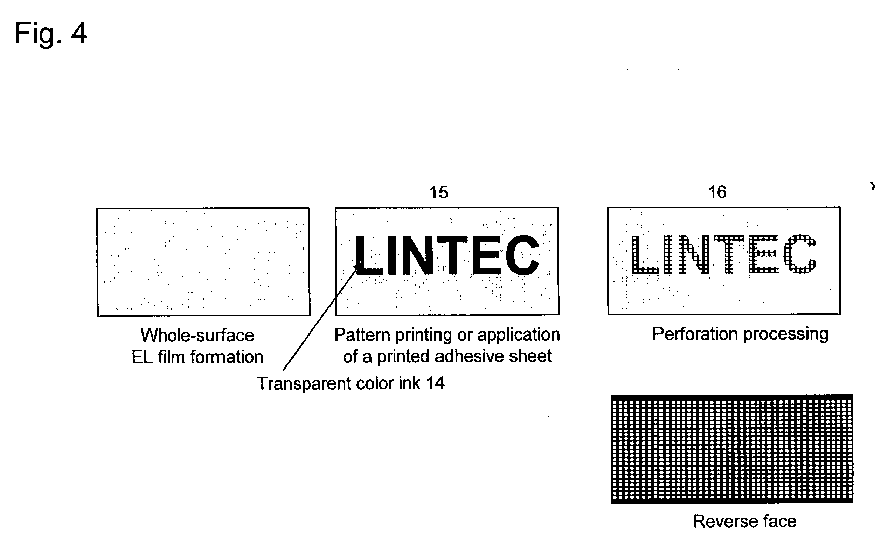

The present invention is explained below with reference to figs. 3 and 4.

A 1^{st} electrode layer 2 (100 nm in thickness) was formed by ITO sputtering on a polyethylene terephthalate sheet 100 µm in thickness (DIAFOIL T-100, Mitsubishi Polyester Film Corporation) serving as a transparent substrate 1. Subsequently, a ZnS:Cu solution (FEL-190, Fujikura Kasei Co., Ltd.) was coated to the ITO face of the 1^{st} electrode layer 2 such that a luminescent layer 4 was formed to have a thickness of 40 µm. After drying using a dryer at 100°C for 30 minutes, a barium titanate solution (FEL-615, Fujikura Kasei Co., Ltd.) was further coated thereto such that a dielectric layer 9 was formed to have a thickness of 30 µm. Drying was carried out using a dryer at 100°C for 30 minutes as described above such that a sheet 10 was obtained. Subsequently, a conductive paste 11 (FEA-685, Fujikura Kasei Co., Ltd.) having functions of a 2^{nd} electrode layer and a see-through control layer was coated in a thickness of 30 µm to the above dielectric layer (barium titanate). The conductive paste was heated using a dryer at 100°C for 30 minutes for curing. An adhesive sheet 12 (PET50 (A) PL SHIN, Lintec Corporation) was laminated thereto such that a luminescent sheet was obtained. Subsequently, text was printed on the transparent substrate 1 side of the luminescent sheet with the use of a transparent color ink 14 such that a designed luminescent sheet 15 was produced. Thereafter, the designed luminescent sheet 15 was subjected to perforation processing using a flat die cutter (RFP-S20, UHT CORPORATION) in a manner such that 1-mm holes were formed thereon at 2-mm intervals between the centers of holes in a matrix pattern. Accordingly, a luminescent decorative material 16 having see-through property was obtained. An AC voltage of 100 V with a frequency of 1000 Hz was applied to the thus obtained luminescent decorative material 16 in the direction of the material's thickness. As a result, the luminescent decorative material was confirmed to be excellent in visibility even at night, and furthermore, to have effects whereby it was possible to see therethrough from one side thereof while it was difficult to see therethrough from the other side thereof.

### (Example 3)

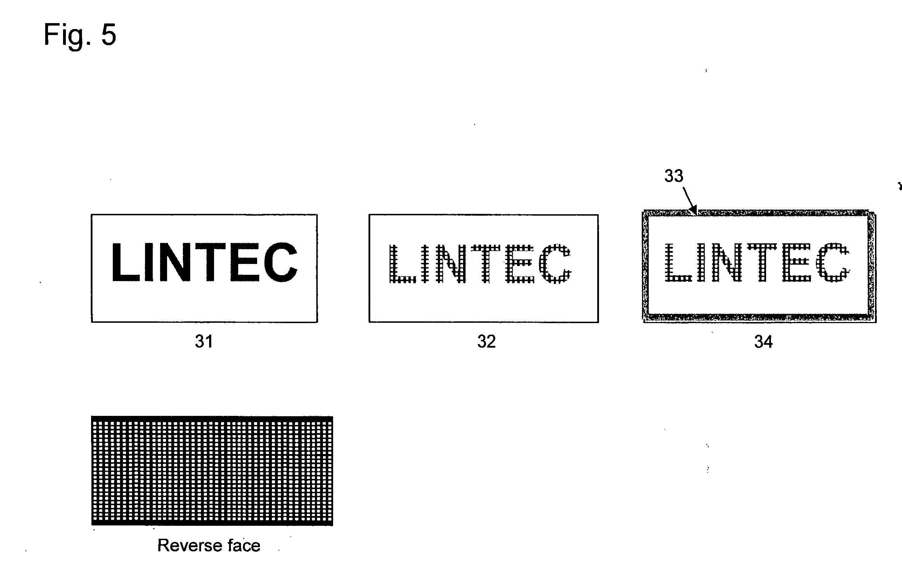

The present invention is explained below with reference to fig. 5.

With the use of a color printer (DocuCentre Color f360, Fuji Xerox Co., Ltd.), text was printed on one surface of a polyethylene terephthalate sheet 100 µm in thickness (DIAFOIL T-100, Mitsubishi Polyester Film Corporation) serving as a transparent substrate and then the entire face of the other side thereof was subjected to printing in black so as to form a see-through control layer. Accordingly, a printed polyethylene terephthalate sheet 31 (100 µm in thickness) was obtained. The printed polyethylene terephthalate sheet 31 was subjected to perforation processing using a flat die cutter (RFP-S20, UHT CORPORATION) in a manner such that 1-mm holes were formed therethrough at 2-mm intervals between the centers of holes in a matrix pattern. Accordingly, a sheet-type decorative material 32 having see-through property was produced. Subsequently, an EL tube 33 (Lumiline^{™} EBAC Corporation) was provided around the edges of the sheet-type decorative material 32 such that a luminescent decorative material 34 having see-through property was obtained. An AC voltage of 100 V with a frequency of 1000 Hz was applied to the EL tube 33. As a result, the luminescent decorative material was confirmed to be excellent in visibility even at night, and furthermore, to have see-through property.

## Claims

1. A luminescent sheet having see-through property, through which see-through holes are formed, and which comprises a means of causing luminescence.

2. The luminescent sheet according to claim 1, wherein the means of causing luminescence is the luminescent sheet itself.

3. The luminescent sheet according to either claim 1 or claim 2, wherein the means of causing luminescence is a luminescent tube that is provided around the edges of the sheet.

4. The luminescent sheet according to any one of the preceding claims, which has been subjected to perforation processing in a matrix pattern.

5. The luminescent sheet according to any one of the preceding claims, which has a see-through control region.

6. A luminescent decorative material, which is obtained by printing on at least one face of the luminescent sheet according to any one of the preceding claims.

7. A method of producing the luminescent sheet according to any one of claims 1, 2, and 4 to 6, comprising carrying out perforation processing on a sheet body comprising a means of causing luminescence so as to impart see-through property to such sheet body.

8. A method of producing the luminescent sheet according to any one of claims 1, 3, and 4 to 6, comprising carrying out perforation processing on a sheet body so as to impart see-through property to such sheet body and then applying a means of causing luminescence to the sheet body.
